**Europäisches Patentamt**

**European Patent Office**

**Office européen des brevets**

(19)

(11) Veröffentlichungsnummer: **0 127 691**
**B1**

(12) # EUROPÄISCHE PATENTSCHRIFT

(45) Veröffentlichungstag der Patentschrift:
**13.05.87**

(21) Anmeldenummer: **83105433.3**

(22) Anmeldetag: **01.06.83**

(51) Int. Cl.⁴: **H 05 K 3/42**

(54) **Verfahren zum Herstellen von gedruckten Schaltungen mit einer Leiterzugebene.**

(43) Veröffentlichungstag der Anmeldung:
**12.12.84 Patentblatt 84/50**

(45) Bekanntmachung des Hinweises auf die Patenterteilung:
**13.05.87 Patentblatt 87/20**

(84) Benannte Vertragsstaaten:
**DE FR GB IT**

(56) Entgegenhaltungen:
**FR - A - 2 307 438**
**US - A - 3 864 147**
**US - A - 4 135 988**
**US - A - 4 351 697**

**METALLOBERFLÄCHE, Band 31, Nr. 11, November 1977, Seiten 497-505, München, DE. G. HERRMANN: "Volladditivtechnik zur Herstellung von Leiterplatten"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Bährle, Dieter K., Cheruskerstrasse 67, D-7036 Schönaich (DE)**
Erfinder: **Schwerdt, Friedrich W., Dipl.-Ing., Nelkenstrasse 23, D-7033 Herrenberg (DE)**

(74) Vertreter: **Kreidler, Eva-Maria, Dr. rer. nat., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren nach dem Oberbegriff des Patentanspruchs 1.

Bei der Herstellung von Leiterplatten nach dem heutigen Stand der Technik werden die Leiterbahnen auf mehreren Ebenen verteilt, und diese Signalebenen werden mit dazwischenliegenden Prepregs und mit der erforderlichen Anzahl von Spannungsebenen zu einer Mehrlagenschaltung zusammenlaminiert. Die Mehrlagenschaltung wird anschliessend an den gewünschten Stellen gebohrt, und durch die Verkupferung der Bohrlöcher wird ein Anschluss an die interne Verdrahtung hergestellt. An die Fertigung von Mehrlagenschaltungen werden heute wegen der hohen Dichte der Verdrahtung bezüglich der angewendeten Materialien und Verfahren besonders hohe Anforderungen gestellt.

Zur Herstellung von Leiterplatten werden zwei Verfahren angewendet. In der Regel wurden bisher die Spannungsebenen nach der subtraktiven Methode hergestellt. Bei diesem Verfahren ist das Ausgangsmaterial ein kupferkaschiertes Halbzeug, z.B. eine glasfaserverstärkte Epoxidharzfolie, auf die ein- oder beidseitig eine z.B. 35 µm dicke Kupferfolie auflaminiert ist. Im Zuge der Weiterverarbeitung werden mehrere, auf ein bestimmtes Format geschnittene, kupferkaschierte Trägerplatten zu einem Paket zusammenngepresst und Löcher für Durchkontaktierungen mit numerisch gesteuerten Automaten gebohrt. Die entgrateten Bohrungen werden durchkontaktiert, indem rein chemisch eine Basisschicht aus Kupfer an den Bohrungswandungen niedergeschlagen wird, die galvanisch verstärkt wird. Die Oberfläche der kupferkaschierten Trägerplatten wird dann durch eine geeignete Vorbehandlung für den eigentlichen Leiterbahndruck vorbereitet. Die Oberfläche wird mit einem Photoresist beschichtet und der Konfiguration der Leiterbahnen entsprechend belichtet. In einem Entwicklungsprozess lässt sich der Negativphotoresist an den nichtbelichteten Stellen entfernen. Die Leiterplatte durchläuft dann eine Ätzanlage, die die Kupferschicht ablöst, wo sie nicht mehr durch den Photoresist geschützt ist. Nach der Entfernung des restlichen Resists befindet sich auf der Epoxidharz-Isolierschicht nur noch die gedruckte Schaltung.

Nachteilig an der subtraktiven Methode ist, dass eine relativ dicke Kupferkaschierung aufgebracht werden muss, die dann durch Ätzen zum grössten Teil wieder abgelöst wird. Dadurch wird dieses Verfahren für feine Verdrahtungsnetzwerke unwirtschaftlich. Es ist daher wünschenswert, anstelle der etwa 35 µm starken Kupferkaschierung eine wesentlich dünnere Kupferkaschierung verwenden zu können. Die bei dem substraktiven Verfahren auftretenden starken Unterätzungen führen ausserdem zu einer Limitierung der Leiterzugbreite, wobei sich Leiterzugbreiten kleiner als 100 µm nach diesen Verfahren nicht mehr herstellen lassen.

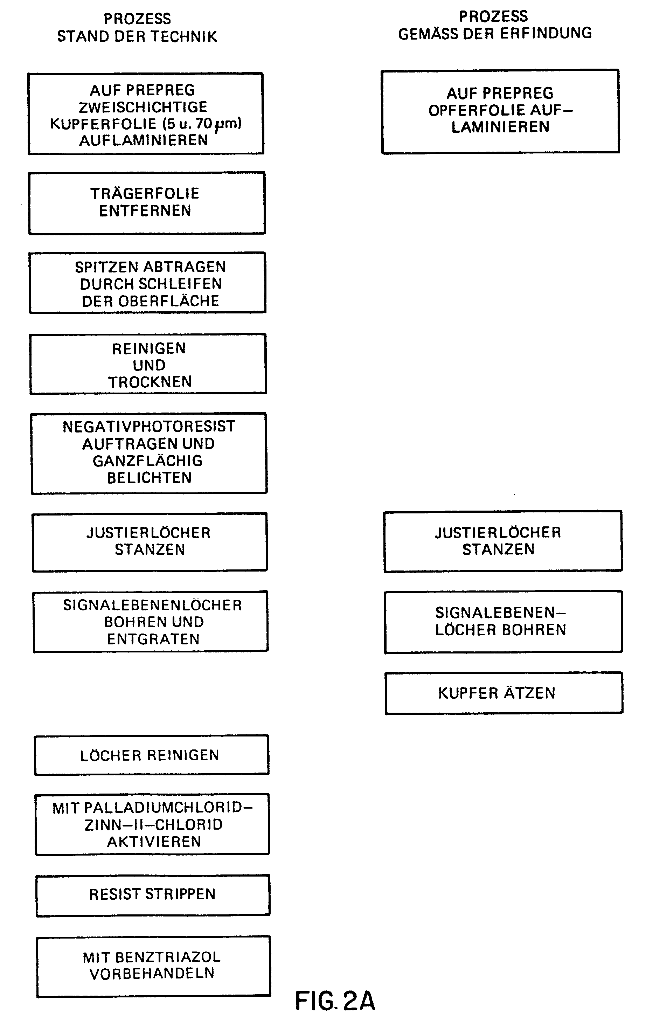

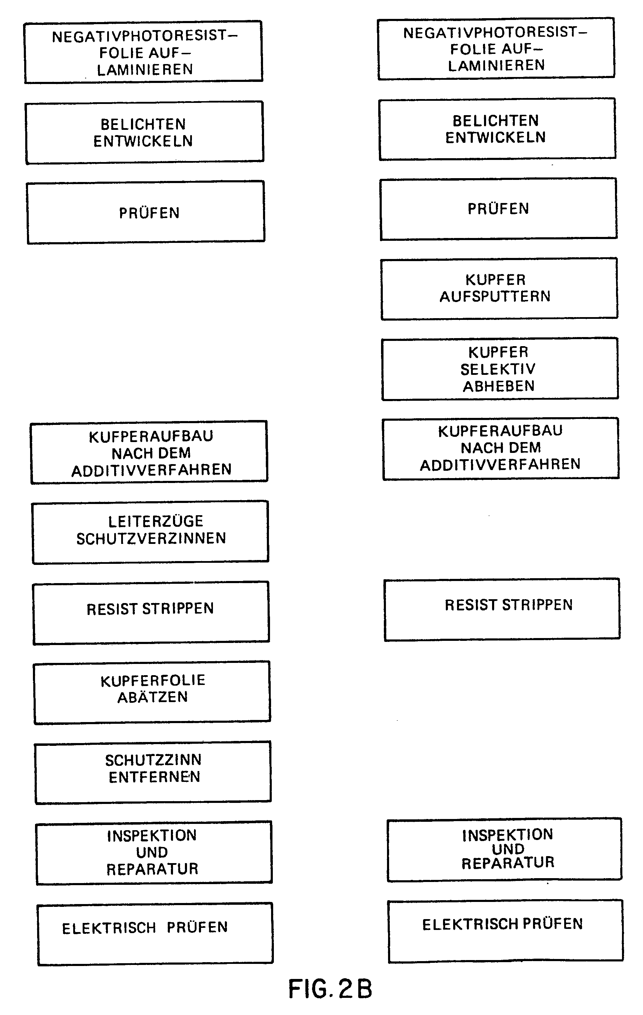

Aus diesen Gründen werden die Signalebenen, die in Mehrlagenschaltungen verwendet werden, nach einem anderen Verfahren, dem Additivverfahren, hergestellt. Das zeitaufwendige und äusserst komplizierte Additivverfahren, welches anhand der Flussdiagramme in den Fig. 2A und 2B, linke Seite, näher erläutert wird, läuft so ab, dass auf eine aus vier Prepreglagen hergestellte Signalebene beidseitig eine zweischichtige Kupferfolie (75 µm stark) auflaminiert wird. Die etwa 70 µm starke Trägerfolie wird anschliessend entfernt. Die Oberfläche der so laminierten und von der Trägerfolie befreiten Teile wird anschliessend unter Zuhilfenahme eines Schleifmehls geschliffen, gereinigt und getrocknet. Dann wird zur Erhöhung der Steifigkeit ein Negativphotoresist aufgetragen und ganzflächig blankbelichtet. Nach dem Einstanzen der Jusiterlöcher werden die Signalebenenlöcher gebohrt, entgratet und gereinigt. Anschliessend werden die Bohrlochwandungen mit Palladiumchlorid-Zinn-II-chlorid aktiviert, und der zuvor aufgetragene Negativphotoresist wird gestrippt. Die Oberfläche der Signalebene wird mit Benzotriazolhaftvermittler behandelt und mit einer Negativphotoresistfolie beschichtet, welche bildmässig belichtet und entwickelt wird. In diesem Zustand werden die Teile dann für ca. 20 Stunden in ein Kupferlangzeitbad getaucht. Während dieser Zeit scheidet sich Kupfer in den herausentwickelten Leiterzugkanälen auf der etwa 5 µm starken Kupferfolie und auf den Bohrlochwandungen bis zur gewünschten Dicke von etwa 40 µm ab. In Anschluss an den Kupferaufbau bringt man auf die Kupferleitungen eine Zinnschicht auf. In dem folgenden Ätzprozess wird die dünne Kupferfolie an den Stellen, an denen sich keine mit Zinn geschützten Leiterzüge befinden, abgelöst. Anschliessend wird die Zinnschicht wieder entfernt. Nach einer Inspektion werden die Teile elektrisch geprüft. Damit ist das Herstellungsverfahren abgeschlossen.

Entscheidend für ein gutes Ergebnis dieses Verfahrens ist die Vorbehandlung der Substratoberflächen vor dem Auflaminieren der Negativphotoresistfolie, denn eine schlechte Resisthaftung führt zum Abheben der Photoresistfolie in dem aggressiven Kupferadditionsbad, so dass sich Kupfer auch an nicht gewünschten Stellen abscheidet und zu Kurzschlüssen in den Signalleitungen führt.

Fehler dieser Art sind, wenn überhaupt, nur äusserst aufwendig zu reparieren.

Aufgabe der Erfindung ist, ein neuartiges Verfahren zur Herstellung von Mehrlagenschaltungen anzugeben, mit dem eine ausgezeichnete Haftung der Photoresistfolie auf der Substratoberfläche erhalten wird und bei dem eine grosse Anzahl von Prozessschritten des zuvor beschriebenen Additivverfahrens entfallen.

Die Aufgabe der Erfindung wird gelöst durch ein Verfahren mit den Merkmalen des Patentanspruchs 1.

Wesentliche Vorteile der vorliegenden Erfindung gegenüber bisher bekannten Verfahren sind, dass die Photoresistfolie direkt auf die Epoxidharzoberfläche auflaminiert werden kann; dass sämtliche mechanischen Oberflächenvorbehandlungen sowie sämtliche Nassprozesse und die Aktivierung der Bohrlochwandungen, das Aufbringen komplizierter Haftvermittler, das Abätzen der Kupferbasisfolie und das Aufbringen und Entfernen der Schutzverzinnung der Kupferleiterzüge entfallen. Die durch Magnetronsputtern aufgebrachte Kupferschicht bildet eine wannenförmige Struktur, auf der später das Kupfer additiv gleichzeitig von drei Seiten aufwächst, wodurch eine erhebliche Steigerung der Verkupferungsgeschwindigkeit bei Leiterzugbreiten < 80 μm möglich ist. Insgesamt handelt es sich bei dem erfindungsgemässen Verfahren um einen kurzen und übersichtlichen Prozess.

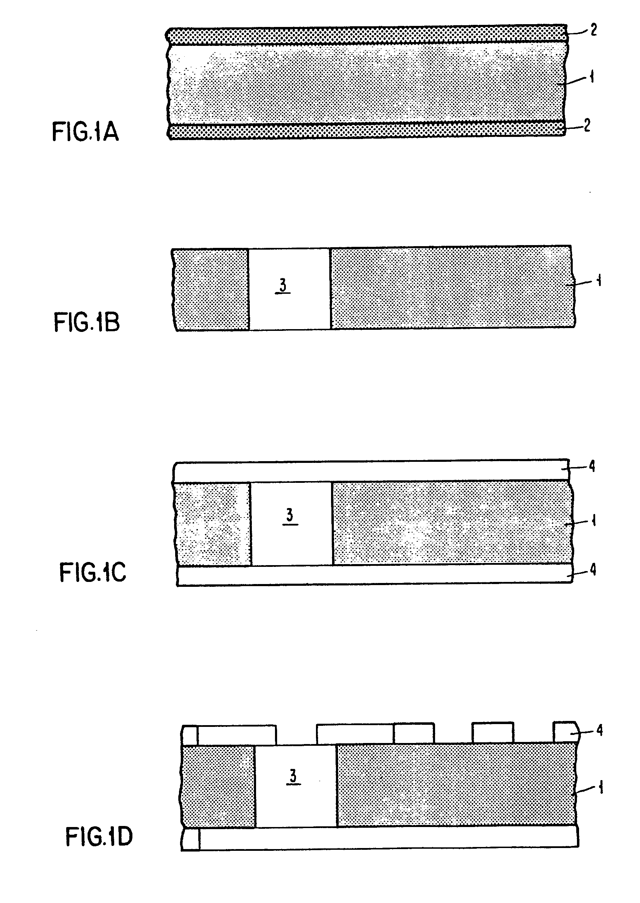

Die Erfindung wird nunmehr anhand eines Ausführungsbeispiels in Verbindung mit den Fig. 1A bis 1H sowie anhand des Flussdiagramms auf der rechten Seite der Fig. 2A und 2B näher erläutert. Weitere Ausgestaltungen der Erfindung sind in den Unteransprüchen im einzelnen angegeben. In den Zeichnungen zeigen die Fig. 1A bis 1H schematische Querschnittsansichten einer gemäss dem bevorzugten Ausführungsbeispiel der vorliegenden Erfindung hergestellten Struktur. In den Fig. 2A und 2B, rechte Seite, sind die dazugehörigen Verfahrensschritte angegeben.

Der Erfindung liegt die Idee zugrunde, die haftungsproblematische Photoresistfolie, die in dem bisherigen Additivverfahren auf die entsprechend vorbereitete Oberfläche einer auflaminierten Kupferfolie auflaminiert wurde, direkt auf die Oberfläche des Epoxidharzlaminats, von dem vorher eine Opferfolie auf Kupfer abgeätzt wurde, aufzulaminieren. Durch diese Vorgehen wird eine ausgezeichnete Haftung zwischen Photoresistfolie und Epoxidharzoberfläche erreicht, weil die Photoresistfolie beim Laminiervorgang selbst in die Poren der aufgerauhten Oberfläche des Epoxidharzsubstrats, welche durch herausgeätzte Kupferdendrite bedingt sind, hineingedrückt wird und sich dadurch nahtlos mit dem Epoxidharzsubstrat verzahnt. Nach dem bildmässigen Belichten und Entwickeln der Photoresistfolie wird die gesamte Signalebenenoberfläche mit Kupfer besputtert. Das Kupfer wird selektiv von der äusseren Oberfläche der Photoresistfolie, welche sehr glatt ist, durch Abziehen mit einem Klebeband oder durch Nassschleifen in einer Durchlaufanlage entfernt. In den Photoresistkanälen, d.h. an den Stellen späterer Leiterzüge und auf den Bohrlochwandungen bleibt das aufgesputterte Kupfer zurück. Dort wächst dann in bekannter Weise nach dem Einbringen in ein Kupferlangzeitbad Kupfer bis zur gewünschten Schichtdicke auf. Zur Fertigstellung der Signalebene braucht nur noch der Photoresist gestrippt zu werden. Alle Folgeprozesse entfallen.

Ausführungsbeispiel:

Gemäss Fig. 1A und dem Flussdiagramm, rechte Seite (Fig. 2A und 2B), werden vier grün eingefärbte Prepregs auf Epoxidharzbasis 1 mit sog. Opferfolien 2 aus Kupfer bei 190°C zusammenlaminiert. Bei den angewendeten 1 oz Opferfolien handelt es sich um Kupferfolien mit einer Dicke von 0,035 mm. Durch das Auflaminieren der Opferfolien wird bewirkt, dass das Signalebenenlaminat stabilisiert wird, und dass sich die dendritische Struktur der Unterseite der Kupferfolien während des Laminierens in der Oberfläche des Epoxidharzlaminats abbildet und dort eine gewünschte Rauhigkeit erzeugt. Es ist erforderlich, die Prepregs einzufärben, weil farbloses Epoxidharz bei der späteren zweiseitigen Belichtung zuviel Licht durchlassen würde, was bei der Belichtung der Vorderseite auch die Mitbelichtung der Rückseite und umgekehrt zur Folge hätte.

In das kupferbeschichtete Laminat 1, 2 werden Justagelöcher (nicht dargestellt) eingestanzt. Anschliessend werden mit Hilfe numerisch gesteuerter Automaten Löcher 3 in das kupferbeschichtete Laminat gebohrt zur Herstellung der Verbindung zwischen der X- und Y-Verdrahtung. Bei dem erfindungsgemässen Verfahren ist von Vorteil, dass vor dem Bohren nicht wie bei bisher bekannten Verfahren (Fig. 2A, linke Seite) eine Photoresistschicht aufgetragen werden muss, weil das Teil 1 durch die Opferfolien 2 bereits über eine genügende Eigenfestigkeit verfügt. Es entfällt auch eine separate Reinigung der Bohrlöcher, weil die Kupferschichten 2 nach dem Bohren in einer Hochdrucksprühanlage mit $CuCl_2$ abgeätzt werden. Nach diesem Schritt liegt ein gebohrtes, gereinigtes und auf der Oberfläche stark aufgerauhtes Laminat (Fig. 1B) vor.

Anschliessend wird eine Negativphotoresistfolie 4, beispielsweise Riston T 168 von der Firma du Pont, welches ein eingefärbtes Polymer auf der Basis von Methylmethacrylat, Pentaerythritoltetraacrylat mit t-Butylanthrachinon als Aktivator ist, beidseitig auf das aufgerauhte Laminat 1 auflaminiert. Während des Laminiervorgangs, der bei etwa 110 bis 120°C und bei einem Vorschub von 1 cm/sec durchgeführt wird, wird diese Photoresistfolie so weich, dass sie sich fugenlos dem Epoxidharzuntergrund in seiner Rauhigkeit anpasst. Der nahtlose Zusammenhalt zwischen Folie und Untergrund konnte durch schliffmikroskopische Aufnahmen nachgewiesen werden. Gegenüber dem herkömmlichen Verfahren (linke Spalte von Fig. 2A) ist von Vorteil, dass die Photoresistfolie 4 auf dem Epoxidharzsubstrat 1 haftet, ohne dass dieses beispielsweise durch Schleifen vorbereitet werden oder ein Haftvermittler wie Benztriazol eingesetzt werden muss.

Das Laminat wird anschliessend in bekannter Weise durch eine Maske auf Vorder- und Rückseite belichtet. Da sich bei dem erfindungsgemässen Verfahren kein Kupfer unter dem Photoresist befindet, wird entsprechend weniger Licht reflektiert, woraus eine etwa 20% längere Belichtungszeit (2 Graukeilstufen mehr) resultiert. Anschliessend wird in bekannter Weise in einer Durchlaufanlage mit 1,1,1-Trichloräthan entwickelt (Fig. 1D).

Nach einer ersten Inspektion wird das Laminat nunmehr in einer Durchlaufsputteranlage, die mit vier magnetronverstärkten Kupferkathoden ausgestattet ist, beidseitig glanzflächig mit Kupfer besputtert. Beide Seiten werden gleichzeitig besputtert, bis eine Schichtdicke von 200 nm erreicht ist. Der Schichtdickenbereich für das aufgesputterte Kupfer beträgt 80 bis 500 nm.

Die Parameter für diesen Verfahrensschritt im einzelnen sind folgende:

| | |
|---|---|
| Startdruck: | $\leq 5 \times 10^{-5}$ mbar; |
| Sauerstoffglimmentladung zur Reinigung: | 2 Minuten; |
| $O_2$-Partialdruck: | $2 \times 10^{-1}$ mbar; |
| Argonpartialdruck: | $5 \times 10^{-3}$ mbar; |
| Argondurchfluss: | 80 cm³/min; |
| Durchlaufgeschwindigkeit: | 1-3 cm/sec; |
| Substrattemperatur: | $\leq 80°C$; |

Sputterrate: ~ 10 nm/sec;

Kupferschichtdicke: 200 nm.

Kupfer 5, 5a (Fig. 1E) scheidet sich während des Sputterns auf der Photoresistoberfläche, den Seitenwandungen der herausentwickelten Leiterzugkanäle, auf deren Boden, d.h. auf der aufgerauhten Epoxidharzoberfläche, und in den Bohrlöchern ab. Diese Kupferabscheidung ersetzt die bisher angewendeten aufwendigen und teuren Palladium-Zinn-II-chlorid-Aktivierungsprozesse (Fig. 2A, linke Seite). Erfindungsgemäss wird in den Leiterzugkanälen durch das Aufsputtern praktisch eine wasserdichte Wanne hergestellt, die es der bei dem nachfolgenden Additivverfahren angewendeten Badflüssigkeit praktisch unmöglich macht, den Photoresist zu unterwandern.

Das Abheben des Kupfers 5a von der Photoresistoberfläche (Fig. 1E, 1F) wird ebenfalls in einer Durchlaufanlage vorgenommen, in der durch nasse, rotierende Schleifwalzen das schlecht auf der Oberfläche des Resists 4 haftende Kupfer 5a restlos entfernt wird. Nur in den Resistkanälen bleibt das aufgesputterte Kupfer als Aktivierungsschicht 5 zurück. Bei diesem Verfahrensschritt hat sich eine Schleifleistung von etwa 160 Watt als optimal erwiesen. Bei Schleifleistungen > 200 Watt wird zuviel von dem Photoresist 4 abgetragen, und die Resistkanten werden unsauber verschliffen.

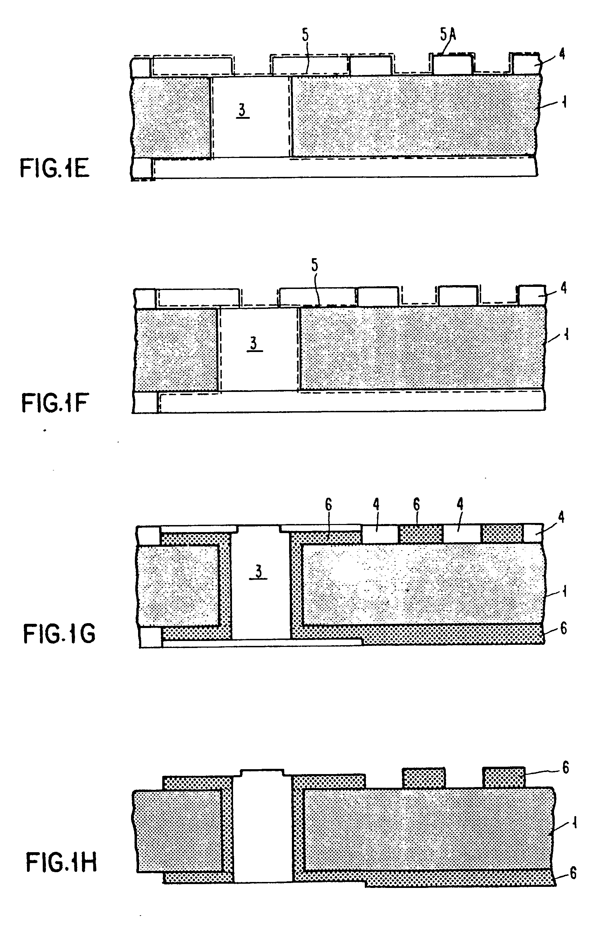

Bei dem nachfolgenden Kupferaufbau nach dem Additivverfahren scheidet sich Kupfer 6 (Fig. 1G) in den Leiterzugkanälen von drei Seiten her gleichzeitig ab. Durch die glatten Photoresistwandungen wird eine äusserst exakte Geometrie der Leiterzugstrukturen erreicht. Die Aufwachsgeschwindigkeit, welche von der Leiterzugbreite abhängig ist, ist bei Leiterzugbreiten < 80 μm bis zu 30% grösser als bei den Prozessoren, bei denen das Kupfer durch Abscheidung nur von unten her aufwächst. Die Betriebsdaten des Kupferbades entsprechen denen des bisher angewendeten Additivverfahrens und können beispielsweise dem Handbuch der Leiterplattentechnik von G. Herrmann, zweite Auflage, Leuze-Verlag, auf Seite 263 entnommen werden.

In einem letzten Schritt wird der Photoresist 4 in bekannter Weise mit Dichlormethan gestrippt unter Erhalt eines Signalcores gemäss Fig. 1H. Da bei dem erfindungsgemässen Verfahren kein ganzflächiger Kupferuntergrund vorlag, braucht dieser auch nicht weggeätzt zu werden. Daher entfallen auch die Verfahrensschritte der Schutzverzinnung und des Abätzens des Zinns von den Kupferleiterzügen. Die nach Abschluss des erfindungsgemässen Verfahrens durchzuführende Inspektion ist nur etwa halb so aufwendig wie die bei dem bisher angewendeten Additionsverfahren (Fig. 2B).

Anschliessend sei noch einmal auf die Vorteile des erfindungsgemässen Verfahrens hingewiesen. Die dünnen Laminate zu Beginn des Verfahrens weisen eine hohe Dimensionsstabilität auf, weil die Kupferfolie abgeätzt und nicht wie im Stand der Technik mechanisch abgezogen wird. Mechanische Oberflächenvorbehandlungen wie Schleifen, sowie das Auftragen komplizierter Haftvermittler, das Reinigen und die Aktivierung der Bohrlochwandungen entfallen. Dadurch, dass die Photoresistfolie direkt auf eine aufgerauhte Epoxidharzoberfläche auflaminiert wird, wird eine hervorragende Haftung des Photoresists erhalten. Die Verkupferung wird eingeleitet durch magnetronverstärktes Sputtern von Kupfer, wobei die Leiterzugkanäle auf allen Seiten verkupfert werden. Die aufgesputterte Kupferschicht wird durch das Additivbad nicht durchdrungen, und das Kupfer wächst gleichzeitig von drei Seiten auf, so dass die Aufkupferungsgeschwindigkeit bei bestimmten Leiterzugbreiten insgesamt um etwa 30% gesteuert wird. Insgesamt werden bei dem erfindungsgemässen Verfahren erheblich weniger Fehler aufgrund von Einschnürungen und Photoresisthaftungsproblemen festgestellt, was zu einer Ausbeutesteigerung führt. Das erfindungsgemässe Verfahren ist kurz und übersichtlich, da sämtliche nachfolgenden Nassprozesse entfallen.

**Patentansprüche**

1. Verfahren zum Herstellen von gedruckten Schaltungen mit einer Leiterzugebene, gekennzeichnet durch folgende Verfahrensschritte:
   a) Auflaminieren einer Opferfolie (2) auf ein Kunstharzprepreg (1);
   b) Bohren von Verbindungslöchern (3);
   c) Abätzen der Opferfolie (2);
   d) Auflaminieren einer Negativphotoresistfolie (4) auf die Oberfläche des Prepregs (1);
   e) Belichten entsprechend dem gewünschten Leiterzugmusters und Entwickeln;
   f) Aufsputtern von Kupfer (5a, 5) auf die Oberfläche des Photoresists (4), auf die Wandungen und den Boden der die Leiterzüge definierenden Photoresistkanäle und die Oberfläche der Bohrlöcher (3);
   g) Abheben des auf die Oberfläche des Photoresists (4) aufgesputterten Kupfers (5a);
   h) Abscheiden von Kupfer (6) auf dem in den Photoresistkanälen und den Bohrlöchern (3) aufgesputterten Kupfer (5) nach dem Additivverfahren;
   i) Strippen des Photoresists (4).

2. Verfahren nach Anspruch 1, dadurch gekennzeichnet, dass die Schritte a) und c) bis i) auf beiden Seiten des Basismaterials (1) gleichzeitig durchgeführt werden.

3. Verfahren nach Anspruch 1, dadurch gekennzeichnet, dass gemäss 1a) Opferfolien (2) aus Kupfer auf ein Prepreg (1) aus Epoxidharz auflaminiert werden.

4. Verfahren nach Anspruch 3, dadurch gekennzeichnet, dass Opferfolien (2) mit einer Schichtdicke von 0,035-0,045 mm bei Temperaturen im Bereich von 170-190°C auf das Prepreg (1) auflaminiert werden.

5. Verfahren nach den Ansprüchen 1 bis 4, dadurch gekennzeichnet, dass eingefärbte Epoxidharzprepregs (1) verwendet werden.

6. Verfahren nach Anspruch 1, dadurch gekennzeichnet, dass gemäss 1c) die Opferfolie (2) in einer Hochdruck-Sprühanlage mit salzsaurer Kupfer-IIchloridlösung abgeätzt wird.

7. Verfahren nach Anspruch 1, dadurch gekennzeichnet, dass gemäss 1d) eine Negativphotoresistfolie (4) durch Laminieren bei Temperaturen im Bereich von 110-120°C nahtlos mit der durch Abätzen der Opferfolie (2) aufgerauhten Oberfläche des Epoxidharzprepregs (1) verbunden wird.

8. Verfahren nach Anspruch 1, dadurch gekennzeichnet, dass vor dem Verfahrensschritt 1f) zur Reinigung der Substrate (1) eine Sauerstoffglimmentladung durchgeführt wird.

9. Verfahren nach Anspruch 1, dadurch gekennzeichnet, dass mittels magnetronverstärkter Hochleistungskathodenzerstäubung Kupfer (5a, 5) auf die Photoresistoberfläche (4) und die Oberfläche und den Boden der die Leiterzüge definierenden Photoresistkanäle und auf die Oberfläche der Bohrlöcher in einer Schichtdicke von 80 bis 500 nm, vorzugsweise 200 nm, aufgebracht wird.

10. Verfahren nach Anspruch 9, dadurch gekennzeichnet, dass die Photoresistkanäle durch das aufgesputterte Kupfer (5) wannenförmig ausgekleidet werden.

11. Verfahren nach den Ansprüchen 1 und 9, dadurch gekennzeichnet, dass das auf die Photoresistoberfläche aufgesputterte Kupfer (5a) durch nasse rotierende Schleifwalzen vollständig von dieser abgehoben wird.

12. Verfahren nach Anspruch 1, dadurch gekennzeichnet, dass gemäss 1h) Kupfer (6) auf dem in den Kanälen aufgesputterten Kupfer (5) von drei Seiten gleichzeitig aufwächst.

## Claims

1. Method of making printed circuits with one conductor plane, characterized by the following process steps:
a) laminating a sacrificial foil (2) onto a synthetic resin prepreg (1);
b) drilling through holes (3);
c) etching off the sacrificial foil (2);
d) laminating a negative photoresist foil (4) onto the surface of the prepreg (1);
e) exposure in accordance with the desired conductor pattern, and developing;
f) sputtering copper (5a, 5) on the surface of the photoresist (4), on the walls and the bottom of the photoresist channels defining the conductors, and on the surface of the drilled holes (3);
g) lift-off of copper (5a) sputtered onto the surface of the photoresist (4);
h) depositing copper (6) on copper (5) sputtered on the photoresist channels and the drilled holes (3), following the additive method;
i) stripping the photoresist (4).

2. Method as claimed in claim 1, characterized in that the steps a) and c) to i) are carried out simultaneously on both sides of the base material (1).

3. Method as claimed in claim 1, characterized in that in accordance with 1a) sacrificial copper foils (2) are laminated onto a prepreg (1) of epoxy resin.

4. Method as claimed in claim 3, characterized in that sacrificial foils (2) with a layer thickness of 0.035-0.045 mm are laminated onto the prepreg (1) at temperatures in the range of 170-190°C.

5. Method as claimed in one of claims 1 to 4, characterized in that dyed epoxy resin prepregs (1) are used.

6. Method as claimed in claim 1, characterized in that in accordance with 1c) the sacrificial foil (2) is etched off in a high pressure spraying system with hydrochloric copper-ll-chloride solution.

7. Method as claimed in claim 1, characterized in that in accordance with 1d) a negative photoresist foil (4) is bonded by lamination, at temperatures in the range of 110-120°C, without any seams to the surface of the epoxy resin prepreg (1) roughened by the etching-off of the sacrificial foil (2).

8. Method as claimed in claim 1, characterized in that prior to process step 1f) an oxygen glow discharge is carried out to clean the substrate (1).

9. Method as claimed in claim 1, characterized in that by means of magnetron-enhanced high efficiency cathode sputtering, copper (5a, 5) is applied onto the surface and the bottom of the photoresist channels defining the conductors, and onto the surface of the drilled holes in a layer thickness of 80 to 500 nm, preferably 200 nm.

10. Method as claimed in claim 9, characterized in that the photoresist channels are coated tub-like by the sputtered-on copper (5).

11. Method as claimed in claims 1 and 9, characterized in that the copper (5a) sputtered onto the photoresist surface is completely removed therefrom by means of wet, rotating scrubbing rollers.

12. Method as claimed in claim 1, characterized in that in accordance with 1h) copper (6) grows from three sides simultaneously on copper (5) sputtered on in the channels.

## Revendications

1. Procédé pour la fabrication de circuits imprimés avec un plan de conducteurs, caractérisé en ce qu'il comprend les étapes suivantes:
a) placage d'une feuille métallique perdue (2) sur un pré-imprégné de résine synthétique (1);
b) perçage de trous de connexion (3);
c) enlèvement par attaque chimique de la feuille perdue (2);
d) placage d'une feuille de résine photo-sensible négative (4) sur la surface du pré-imprégné (1);
e) insolation selon le motif du circuit souhaité, et développement;
f) dépôt par vaporisation de cuivre (5a, 5) sur la surface de la résine photo-sensible (4), sur les parois et le fond des canaux de résine photo-sensible définissant conducteurs, et sur la surface des trous (3);
g) élimination du cuivre (5a) déposé par vaporisation sur la surface de la résine photo-sensible (4);
h) dépôt de cuivre (6) au bain sur le cuivre (5) vaporisé dans les canaux de résine photo-sensible et les trous (3) selon le procédé additif;
i) enlèvement de la résine photo-sensible (4).

2. Procédé selon la revendication 1, caractérisé en ce que les étapes a) et c) à i) sont effectuées simultanément sur les deux côtés du matériau de base (1).

3. Procédé selon la revendication 1, caractérisé en ce que, dans l'étape 1a), des feuilles perdues (2) de cuivre sont plaquées sur pré-impregné (1) de résine époxyde.

4. Procédé selon la revendication 3, caractérisé en ce que des feuilles perdues (2) d'une épaisseur de 0,035-0,045 mm sont plaquées à des températures comprises entre 170 et 190°C sur le pré-impregné (1).

5. Procédé selon l'une quelconque des revendications 1 à 4, caractérisé en ce que des pré-imprégnés (1) colorés de résine époxyde sont utilisés.

6. Procédé selon la revendication 1, caractérisé en ce que dans l'étape 1c) la feuille perdue (2) est enlevée dans une installation de pulvérisation à haute pression, avec une solution chlorhydrique de chlorure de cuivre II.

7. Procédé selon la revendication 1, caractérisé en ce qu'à l'étape 1d), une feuille de résine photosensible négative (4) est liée intimement par placage à des températures comprises entre 110 et 120°C, à la surface du pré-imprégné de résine époxyde (1) rendue rugueuse par l'enlèvement par attaque chimique de la feuille perdue (2).

8. Procédé selon la revendication 1, caractérisé en ce qu'avant l'étape 1f), une décharge par effluves dans l'oxygène est effectuée pour le nettoyage des substrats (1).

9. Procédé selon la revendication 1, caractérisé en ce que du cuivre (5a, 5) est déposé par vaporisation cathodique à haute puissance amplifiée par magnétron, sur la surface de la résine photo-sensible (4), sur la surface et le fond des canaux de résine photo-sensible (4) définissant les circuits conducteurs, et sur la surface des trous, avec une épaisseur de couche de 80 à 500 nm, de préférence de 200 nm.

10. Procédé selon la revendication 9, caractérisé en ce que les canaux de résine photo-sensible sont revêtus en forme de cuvette de cuivre (5) vaporisé.

11. Procédé selon les revendications 1 et 9, caractérisé en ce que le cuivre (5a) vaporisé sur la surface de la résine photo-sensible est totalement éliminé de celle-ci par des cylindres rotatifs de polissage au mouillé.

12. Procédé selon la revendication 1, caractérisé en ce que dans l'étape 1h) le cuivre (6) est déposé au bain simultanément sur trois côtés sur le cuivre (5) déposé par vaporisation dans les canaux.

FIG.1A

FIG.1B

FIG.1C

FIG.1D

FIG.1E

FIG.1F

FIG.1G

FIG.1H

PROZESS
STAND DER TECHNIK

PROZESS
GEMÄSS DER ERFINDUNG

AUF PREPREG
ZWEISCHICHTIGE
KUPFERFOLIE (5 u. 70 μm)
AUFLAMINIEREN

AUF PREPREG
OPFERFOLIE AUF—
LAMINIEREN

TRÄGERFOLIE
ENTFERNEN

SPITZEN ABTRAGEN
DURCH SCHLEIFEN
DER OBERFLÄCHE

REINIGEN
UND
TROCKNEN

NEGATIVPHOTORESIST
AUFTRAGEN UND
GANZFLÄCHIG
BELICHTEN

JUSTIERLÖCHER
STANZEN

JUSTIERLÖCHER
STANZEN

SIGNALEBENENLÖCHER
BOHREN UND
ENTGRATEN

SIGNALEBENEN—
LÖCHER BOHREN

KUPFER ÄTZEN

LÖCHER REINIGEN

MIT PALLADIUMCHLORID—
ZINN—II—CHLORID
AKTIVIEREN

RESIST STRIPPEN

MIT BENZTRIAZOL
VORBEHANDELN

FIG. 2A

| NEGATIVPHOTORESIST—FOLIE AUF—LAMINIEREN | NEGATIVPHOTORESIST—FOLIE AUF—LAMINIEREN |

| BELICHTEN ENTWICKELN | BELICHTEN ENTWICKELN |

| PRÜFEN | PRÜFEN |

| | KUPFER AUFSPUTTERN |

| | KUPFER SELEKTIV ABHEBEN |

| KUFPERAUFBAU NACH DEM ADDITIVVERFAHREN | KUPFERAUFBAU NACH DEM ADDITIVVERFAHREN |

| LEITERZÜGE SCHUTZVERZINNEN | |

| RESIST STRIPPEN | RESIST STRIPPEN |

| KUPFERFOLIE ABÄTZEN | |

| SCHUTZZINN ENTFERNEN | |

| INSPEKTION UND REPARATUR | INSPEKTION UND REPARATUR |

| ELEKTRISCH PRÜFEN | ELEKTRISCH PRÜFEN |

**FIG. 2 B**